# EUROPÄISCHE PATENTSCHRIFT

(11) **EP 0 709 485 B1**
(45) Veröffentlichungstag und Bekanntmachung des Hinweises auf die Patenterteilung: **28.10.1998**
(21) Anmeldenummer: 95111365.3
(22) Anmeldetag: 20.07.1995
(51) Int. Cl.: C23C 16/40, C23C 16/30, B65D 23/08, C08J 7/04

(54) **Verfahren zur Herstellung eines Behälters aus Kunststoff mit einer Sperrbeschichtung**
Process for producing a plastic container with a barrier coating
Procédé pour la production d'un récipient en plastique avec une couche barrière

(30) Priorität: 27.10.1994 DE 4438359
(43) Veröffentlichungstag der Anmeldung: 01.05.1996
(73) Patentinhaber: Schott Glas, 55122 Mainz (DE); CARL-ZEISS-STIFTUNG trading as Schott Glas, 55122 Mainz (DE)
(72) Erfinder: Walther, Marten, Dr., D-55270 Bubenheim (DE); Heming, Martin, Dr., D-55442 Stromberg (DE); Spallek, Michael, Dr., D-55218 Ingelheim (DE); Zschaschler, Gudrun, D-55270 Zornheim (DE)

(56) Entgegenhaltungen:
- EP-A- 0 460 796
- EP-A- 0 607 573
- WO-A-93/24243
- GB-A- 2 246 795
- DATABASE WPI Section Ch, Week 9528 Derwent Publications Ltd., London, GB; Class A92, AN 95-213060 & JP-A-07 126 419 ( TOPPAN PRINTING CO LTD) , 16.Mai 1995
- PATENT ABSTRACTS OF JAPAN vol. 014 no. 058 (M-0930) ,2.Februar 1990 & JP-A-01 283136 (MITSUBISHI MONSANTO CHEM CO;OTHERS: 01) 14.November 1989,
- DATABASE WPI Section Ch, Week 9209 Derwent Publications Ltd., London, GB; Class A32, AN 92-069807 & JP-A-04 014 440 ( TORAY IND INC) , 20.Januar 1992

## Beschreibung

Die Erfindung betrifft ein Verfahren zur Herstellung eines Behälters aus Kunststoff mit einer Sperrbeschichtung, die aus einem Schichtenpaket mit wenigstens zwei sequentiell angeordneten Sperrschichten unterschiedlicher Zusammensetzung besteht.

Behälter aus Kunststoff, z. B. Flaschen, Kanister, haben gegenüber den bekannten Behältern aus Glas oder Blech den Vorteil eines geringen Gewichtes, einer hohen Bruchsicherheit und einer geringen Korrosionsneigung, verbunden mit vorteilhaftem Verhalten beim Bersten des Behälters. Nachteilig allerdings bei Kunststoffbehältern ist die mangelhafte Diffusionssperrwirkung der verwendeten Kunststoffmaterialien. Je nach verwendetem Material lassen die Kunststoffe mehr oder weniger große Mengen an Sauerstoff, Kohlendioxid, Wasserdampf, Lösungsmitteln, wie Alkohole, Aromastoffe und dergleichen diffundieren.

Es hat daher nicht an Versuchen gefehlt, die Diffusionssperrwirkung von Kunststoffbehältern zu verbessern. Kunststoffbehälter, die aus einem mehrschichtigen Laminat aus verschiedenen Kunststoffen bestehen, haben sich wegen ihrer zum Teil teuren Rohstoffe und ihrer komplizierten und damit kostspieligen Herstellung nicht durchsetzen können. Darüber hinaus ist auch bei diesen Laminatbehältern die Diffusion immer noch so groß, daß eine echte Langzeitbeständigkeit von z. B. über einem Jahr für hohe Ansprüche nicht erreichbar ist.

Ein anderer Weg besteht darin, auf die Oberfläche eines Kunststoffbehälters eine sogenannte Sperrschicht aufzubringen, die die Diffusion von Gasen sowie ggf. einen Angriff des in dem Behälter gelagerten Materials auf den Kunststoff verhindern soll. In US-PS 45 52 791 ist ein Behälter beschrieben, der auf seiner Außenseite eine Sperrschicht aus anorganischen Oxiden trägt. Die Wirkungsweise der Sperrschicht wird so beschrieben, daß die anorganischen Oxide teilweise in das Polymer hineindringen und die Zwischenräume und Porositäten zwischen den Polymerketten verstopfen. Die meisten anorganischen oder metallischen Oxide sind zu diesem Zweck geeignet, bevorzugt werden die Oxide des Siliziums, Aluminiums, Titans und Tantals. Die Dicke der Oxidschicht reicht von weniger als 50 nm bis über 500 nm. Das Aufbringen der Schicht erfolgt mittels eines PVD-(Physical-Vapour-Deposition )-Verfahren durch Verdampfen des mittels einer Gasentladung ionisierten Schichtmaterials im elektrischen Feld. Obwohl die Diffusionssperrwirkung durch diese Sperrschicht um den Faktor 3 verbessert werden kann, ist das Ergebnis noch verbesserungsbedürftig. Bei kleinen Schichtdicken ist die Diffusionssperrwirkung nicht befriedigend, bei großen Schichtdicken besteht die Gefahr des Abplatzens der Schicht, insbesondere dann, wenn der Behälter einer Sterilisation im Autoklaven unterzogen werden muß.

Aus EP 0 460 796 A2 ist ein Behälter mit einer verbesserten Diffusionssperrwirkung bekannt. Dieser Behälter besitzt eine Diffusionssperrbeschichtung, die aus einem Schichtenpaket aus zwei sequentiell angeordneten anorganischen Sperrschichten unterschiedlicher Zusammensetzung, nämlich SiO und SiO₂ besteht. Es wechseln sich SiO mit SiO₂-Schichten ab. Die SiO-Schichten besitzen eine Dicke von 10 bis 75 nm und die SiO₂-Schichten eine Dicke von wenigstens 20 nm. Durch den Aufbau aus zwei Schichten unterschiedlicher Zusammensetzung ist eine erhebliche Verbesserung der Diffusionssperrwirkung gegeben. Nachteilig ist jedoch, daß für eine gute Sperrwirkung eine verhältnismäßig dicke Beschichtung erforderlich ist. Eine dicke Beschichtung neigt aber aufgrund ihrer Sprödigkeit zur Rißbildung und zum Abplatzen, da sich mit zunehmender Dicke die Biegsamkeit und die Fähigkeit, innere Spannungen zu ertragen, vermindert.

Die Aufgabe der Erfindung besteht darin, einen Behälter der eingangs genannten Art so weiterzubilden, daß eine Verbesserung des Sperrvermögens, eine größere Flexibilität und eine höhere mechanische Stabilität der Sperrbeschichtung erreicht wird. Ferner soll der Behälter mit Beschichtung ohne Schwierigkeiten im Autoklaven sterilisierbar sein.

Diese Aufgabe wird mit einem Verfahren mit den Merkmalen des Patentanspruchs 1 gelöst.

Es hat sich gezeigt, daß durch Aufbringen einer Sperrbeschichtung, die aus wenigstens zwei sequentiell angeordneten Sperrschichten besteht, von denen jeweils die eine aus einem oder mehreren anorganischen Oxiden, Nitriden oder Oxinitriden bzw. einer Mischung davon (anorganische Schicht) und die andere aus einem organischen polymeren Material (organische Schicht) besteht, die Sperrwirkung der Beschichtung und die mechanische Stabilität beträchtlich erhöht werden können.

Als anorganische Oxide sind die meisten metallischen Oxide geeignet, wie bereits in US-PS 4,552,791 beschrieben, wobei unter Metallen auch Halbmetalle verstanden werden. Besonders geeignet sind die Oxide des Siliziums, Aluminiums, Titans, Zinns oder Tantals. Als Material für die anorganische Schicht sind auch Nitride und Oxinitride geeignet, sofern sie gegenüber den in dem Behälter zu lagernden Substanzen und der Atmosphäre eine ausreichende chemische Beständigkeit besitzt, was im übrigen natürlich auch für die Oxide gilt. Geeignete Nitride sind z. B. Nitride des Bors, des Aluminiums, des Siliziums und des Titans.

Als Oxinitride kommen vor allem die bekannten Verbindungen des Sialon-Typs (Silicium-Aluminium-Oxinitrid), aber auch Siliciumoxinitride zur Anwendung. Bevorzugt wird jedoch wegen der einfachen Herstellbarkeit die Verwendung oxidischer oder nitridischer Sperrschichten.

Die Dicke einer einzelnen anorganischen Sperrschicht soll zwischen 2 und 300 nm liegen, insbesondere zwischen 5 und 200 nm.

Als Material für die organische Sperrschicht sind alle polymeren Materialien geeignet, die gegenüber den in dem Behälter zu lagernden Materialien inert sind und sich in Form einer Schicht auf der Behälterwandung niederschlagen lassen. Die organische Sperrschicht kann aus einem Monomer mit anschließender Polymerisation, z. B. einer Plasmapolymerisation, UV-Polymerisation oder Elektonenstrahl-Polymerisation erzeugt werden. Je nach den Bedingungen, unter denen die organische Sperrschicht aufgebracht wird, kann das polymere organische Material auch in an sich bekannter Weise noch Sauerstoff und/oder Stickstoffatome enthalten. Bevorzugt ist das Aufbringen der organischen Sperrschicht durch Plasmapolymerisation.

Besonders geeignete Materialien für die organische Sperrschicht sind z. B. Polyäthylen, Parylen, Polybuten, Phthalocyanine, Polypropylen, Polystyrol oder aus Hexamethyldisiloxan mittels Plasmapolymerisation niedergeschlagene Polymere.

Die organische Sperrschicht soll 2 bis 1000 nm, insbesondere 5 bis 500 nm und ganz besonders bevorzugt 10 bis 200 nm dick sein. Unterhalb einer Schichtdicke von 2 nm ist es schwierig, einen zusammenhängenden Film zu erzeugen, bei Verwendung von Schichtdicken oberhalb von 1000 nm für die organische Sperrschicht wird die Dicke eines mehrere organische Schichten enthaltenden Schichtenpakets leicht zu groß.

Die Erzeugung dünner Filme aus den genannten Sperrschichtmaterialien ist seit vielen Jahren bekannt. Verschiedene Techniken zur Erzeugung organischer Polymerfilme sind z. B. von A. M. Mearns in: Thin Solid Films, 3 (1969) 201-228-Elsevier, Lausanne beschrieben; die Herstellung von Oxid-, Nitrid- oder Oxinitrid-Filmen kann z. B. nach den in US-PS 51 54 943, in Applied Optics, Vol. 25, No. 21, Seiten 3808-3809 (1986) oder in Japanese Journal of Applied Physics, Vol. 27, No. 1, January 1988, Seiten L 21 bis L 23 beschriebenen Verfahren erfolgen.

Die Sperrbeschichtung besteht im einfachsten Fall aus einer anorganischen und einer organischen Sperrschicht. Bevorzugt wird allerdings, wenn wenigstens zwei anorganische Sperrschichten in der Sperrbeschichtung vorhanden sind. Die Sperrbeschichtung kann so ausgeführt sein, daß, von der Behälteroberfläche aus gesehen, zunächst eine anorganische Sperrschicht angeordnet ist, dann folgt eine organische Sperrschicht und danach wiederum eine anorganische Sperrschicht. Auf der anorganischen Sperrschicht kann dann noch einmal eine organische Sperrschicht angeordnet sein, was aber nicht unbedingt erforderlich ist. Die Sperrbeschichtung kann jedoch, von der Behälteroberfläche aus gesehen, auch mit einer organischen Sperrschicht beginnen und man hätte somit bei einer Beschichtung mit zwei anorganischen Sperrschichten die Schichtenfolge: organisch / anorganisch / organisch / anorganisch und ggf. noch einmal organisch. Sehr gute Ergebnisse erzielt man mit Schichtenpaketen, die jeweils etwa 10 bis 20 anorganische und organische Schichten mit einer Stärke zwischen 8 und 50 nm bzw. 10 bis 100 nm besitzen. Aus Gründen der Prozeßökonomie sollte die Schichtdicke des gesamten Schichtenpaketes jedoch 0,1 mm, vorzugsweise 0,01 mm, nicht überschreiten.

Falls die aus Richtung des Kunststoffbehälters gesehene erste Schicht eine anorganische Sperrschicht ist, kann es zweckmäßig sein, zur Verbesserung der Haftung zwischen der anorganischen Schicht und der Behälterwandung eine Haftvermittlerschicht anzuordnen. Derartige Haftvermittlerschichten sind wohlbekannt und können z. B. aus kohlenwasserstoffhaltigen Si-, Al-, Ti-Oxid-Schichten bestehen. Eine weitere Möglichkeit besteht darin, in der Oberfläche des Kunststoffbehälters, z. B. durch lonenätzen oder durch eine Fluorbehandlung aktive Zentren zu schaffen, die die Haftvermittlung bewirken. Ist die erste Sperrschicht eine organische Sperrschicht, kann auf eine Haftvermittlerschicht im allgemeinen verzichtet werden. Falls jedoch die organische Sperrschicht keine gute Haftung an dem Behältermaterial besitzt, kann eine derartige Haftvermittlerschicht auch dann von Vorteil sein, wenn als erste Schicht eine organische Sperrschicht angeordnet ist.

Anorganische und organische Sperrschichten müssen nicht exakt voneinander getrennt sein, sondern es kann zwischen diesen Schichten eine Zone auftreten, in der sich die beiden Schichten mischen. Des Weiteren kann die organische Sperrschicht bis zu 10 Metallatome pro Kohlenstoffatom enthalten, wobei 0,1 bis 5 Metallatome pro Kohlenstoffatom bevorzugt sind. Solche organischen Schichten, die Metallatome enthalten, erzeugt man mittels eines PCVD (Plasma-Chemical-Vapour-Deposition)-Verfahrens aus geeigneten organischen und metallorganischen Precursor-Verbindungen. Organische Schichten aus metallorganischen Precusoren sind besonders günstig, weil auf Ihnen die anorganische Schicht besonders gut haftet. Dabei ist es wegen der chemischen Verwandtschaft vorteilhaft, die gleichen Metallatome sowohl in der organischen als auch in der oxidischen Schicht zu verwenden. Es wird daher bevorzugt, wenn die organische Schicht solche Metallatome enthält, die auch in der Oxidschicht vorkommen.

Besonders günstig ist es, wenn die Konzentration an Metallatomen in der organischen Sperrschicht nicht über die gesamte Dicke der Schicht konstant ist, sondern in der Mitte der Schicht geringer ist, als an den zu den anorganischen Schichten weisenden Grenzflächen. Auf diese Weise erhält man an den Grenzflächen einen besonders guten Haftungseffekt der anorganischen Sperrschicht, während in der Mitte der organischen Sperrschicht die organischen Eigenschaften der Schicht ihr volles Ausmaß erreichen.

Auch die anorganische Schicht kann, je nach Herstellungsweise, eingebaute Kohlenstoffatome besitzen. Das kann insbesondere dann auftreten, wenn die anorganische Schicht durch Zersetzen von metallorganischen Verbindungen hergestellt wird. Je nach den Zersetzungsbedingungen verbleibt dann in der sich bildenden anorganischen Schicht ein mehr oder minder großer Anteil an C-Atomen. Diese Schichten, die nicht mehr als 0,1 C-Atome pro Metallatom, höchstens jedoch 0,5 C-Atome pro Metallatom besitzen sollten, haben gegenüber reinen anorganischen Schichten den Vorteil, daß sie eine bessere Haftung gegenüber der organischen Schicht besitzen. Wegen der besseren Diffusionssperrwirkung werden jedoch im allgemeinen möglichst kohlenstoffarme bis kohlenstofffreie Schichten bevorzugt.

Die Herstellung der Sperrbeschichtung erfolgt mittels des PCVD (Plasma-Chemical-Vapour-Depositon)-Verfahrens insbesondere jedoch des PICVD (Plasma-Impuls-Chemical-Vapour-Deposition)-Verfahrens. Das PICVD-Verfahren gestattet es besonders einfach, die gesamte Sperrbeschichtung herzustellen, weil die benötigten Einzelschichten mit ihren unterschiedlichen Eigenschaften mit dem gleichen Prozeß aufgebracht werden können, während mit der Hochvakuumverdampfung und der Kathodenzerstäubung vor allem nur die eigentliche anorganische Sperrschicht hergestellt werden muß, wohingegen die organischen Schichten auch durch andere Verfahren, z. B. Aufsprühen von flüssigen Monomeren oder Einleiten von gasförmigen Monomeren und anschließende Polymerisation aufgebracht werden können. Beide Verfahren erlauben den Aufbau einer dichten Sperrbeschichtung ohne starke Temperaturbelastung des Substrats. Der Beschichtungsprozeß nach dem PICVD-Verfahren wird erleichtert, wenn die organische und die anorganische Sperrschicht verwandt sind, wenn sie z. B. ein gemeinsames Metallatom enthalten, weil dann ein gemeinsames Schichtbildnergas verwendet werden kann. Verwendet man beispielsweise in einem PCVD oder PICVD-Verfahren ein Reaktionsgasgemisch aus metallorganischen Verbindungen, wie HMDSO (Hexamethyldisiloxan), TIPT (Tetraisopropylorthotitanat), oder Trimethylaluminium und Sauerstoff, so können je nach Sauerstoffgehalt reine Oxidschichten oder organische Polymerschichten mit einem Gehalt entsprechender Metallatome erzeugt werden. Setzt man z. B. die siliziumorganische Verbindung Hexamethyldisiloxan ein, so kann man je nach Sauerstoffgehalt im Reaktionsgas und ggf. durch Änderung von Leistungsparametern des Plasmaprozesses Schichten erzeugen, die von reinen SiO₂-Schichten bis zu Siliconharz-Schichten reichen.

Es ist aber auch möglich, die organische und die anorganische Schicht aus unterschiedlichen Ausgangsgasen herzustellen. So kann man beispielsweise die organische Schicht aus Hexamethyldisiloxan mit geringem Anteil an Sauerstoff im Reaktionsgasgemisch erzeugen und die anorganische Schicht als TiO₂-Schicht aus TiCl₄. Die Oxide von Silicium, Titan, Aluminium, Zinn und Tantal haben sich als Material für die anorganische Sperrschicht bewährt.

Statt der genannten Sauerstoffverbindungen für die anorganische Sperrschicht sind auch die entsprechenden Nitrid- und Oxinitridverbindungen einsetzbar, sofern sie chemisch inert genug sind. Eine Dotierung der anorganischen Sperrschicht mit Zr, Zn, In, Pb, W, Cu, Cr, Fe, Mn, Sb, Co, Ba, Mg wie in EP 0 460 796 A1 beschrieben, beeinflußt ebenfalls die anorganische Sperrschicht gemäß der Erfindung positiv. Mischungen der genannten Verbindungen haben sich ebenfalls als geeignet erwiesen.

Als Behältermaterial kommen alle für diesen Zweck bekannten und verwendeten Kunststoffe in Frage, sofern sie den Beschichtungsbedingungen, d. h. insbesondere der bei der Beschichtung auftretenden thermischen Belastung gewachsen sind. Sehr häufig werden solche Behälter nach dem Spritzgieß-, Spritzblas- oder Folienblasverfahren hergestellt. Will man Behälter herstellen, die im Autoklaven thermisch sterilisierbar sind, sind nicht mehr alle Kunststoffe als Behältermaterial geeignet. Autoklavierbare Kunststoffe sind z. B. Polycarbonat, Polypropylen, Polyethylen, cyclische Olefinpolymere, Polybuten, Polymethylpenten.

Die Sperrbeschichtung kann sowohl auf der Außenseite des Behälters als auch auf seiner Innenseite oder auf beiden Seiten aufgetragen sein. Im allgemeinen ist es ausreichend, wenn eine Seite des Behälters beschichtet ist. Bei empfindlichen Inhaltsstoffen empfiehlt es sich, die Beschichtung auf der Innenseite des Behälters vorzunehmen, um einen Kontakt des Behälterinhalts mit dem Behältermaterial zu vermeiden. Wenn der Behälter innen und außen, also rundum beschichtet ist, kann auch ein Behälter, dessen Material sonst eine nicht ausreichende Stabilität gegenüber heißem Wasserdampf besitzt, einer Sterilisation im Autoklaven unterzogen werden. Für bestimmte pharmazeutische Anwendungen werden Kunststoffbehälter häufig innen mit einer Siliconschicht oder einer hydrophoben organischen Schicht versehen, um ein bestimmtes Gleit- oder Auslaufverhalten zu erreichen. Eine solche Gleitschicht kann ohne Schwierigkeiten zusätzlich auf die Sperrbeschichtung aufgebracht werden. Es handelt sich bei derart beschichteten Behältern z. B. um Spritzen, bei denen durch die Gleitbeschichtung ein ruckfreier Kolbenvorschub gewährleistet wird. Ein bekanntes Herstellungsverfahren für eine Gleitbeschichtung ist das Aufsprühen von Silikonöl (-emulsionen). Es ist weiterhin üblich, bei wertvollen Inhaltsstoffen die Innenwand des Behälters mit einer Schicht zu versehen, die ein gutes Auslaufverhalten des Inhaltsstoffes ermöglicht. Als dafür geeignete Schichten sind Silikonschichten und fluorhaltige Schichten bekannt. Auch solche Schichten lassen sich beispielsweise durch Aufsprühen oder einen CVD-Prozess ohne Schwierigkeiten auf die Sperrbeschichtung aufbringen.

Durch den Aufbau der Sperrbeschichtung aus einem Schichtenpaket mit anorganischen und anorganischen Sperrschichten wird zum einen eine sehr gute Sperrwirkung erreicht, zum anderen besitzt die Sperrbeschichtung eine ausgezeichnete Flexibilität.

### Beispiele:

Die Erfindung wird anhand der nachstehenden Beispiele weiter beschrieben. In allen Beispielen wurden Fläschchen aus Polycarbonat (PC), hergestellt aus Makrolon 2458 der Bayer AG, Leverkusen, eingesetzt. Die Fläschchen hatten einen Außendurchmesser im zylindrischen Teil von 24 mm, eine Höhe von 58 mm, eine Wandstärke im zylindrischen Teil von 1 mm und ein nutzbares Volumen von 18 ml. Die Diffusionswerte für die unbeschichteten Fläschchen, bezogen auf 1 m² Oberfläche, waren wie folgt: CO₂: 687 cm³/m²/d/bar; O₂: 138 cm³/m²/d/bar; Wasser: 2,5 g/m²/d.

### Beispiel 1:

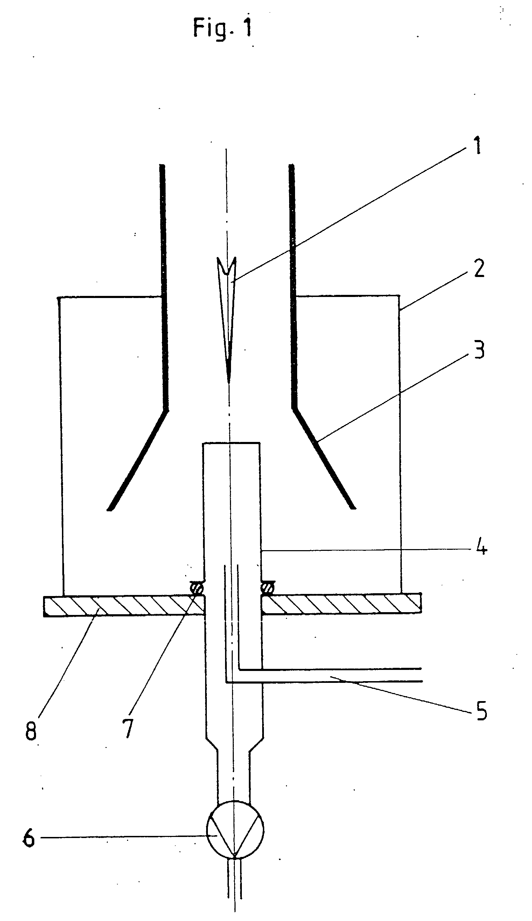

Das PC-Fläschchen wurde mit einer Innenbeschichtung, bestehend aus 5 anorganischen Sperrschichten aus TiO₂ mit einer Dicke von jeweils 20 nm und 6 organischen Sperrschichten mit einer Dicke von jeweils 50 nm beschichtet. Als erste Schicht wurde eine organische Schicht auf die Behälterwandung aufgebracht. Die 5. TiO₂-Schicht wurde noch einmal mit einer organischen Sperrschicht abgedeckt. Das Aufbringen der Schichten erfolgte nach dem PICVD-Verfahren in einer in Figur 1 schematisch dargestellten Vorrichtung. Die Vorrichtung besteht aus einer metallischen Grundplatte 8, die eine metallische Mikrowellenabschirmung 2 trägt. Die Grundplatte 8 ist mit einer Öffnung für die Vakuumleitung 6 versehen. Auf die Öffnung wurde die zu beschichtende Flasche 4 aufgesetzt und mittels der Ringdichtung 7 abgedichtet. die Flasche wurde über die Leitung 6 auf einen Druck von 0,3 mbar evakuiert. Über die Mikrowellenantenne 3 wird eine Mikrowellenstrahlung 1 impulsweise in den aus Abschirmung 2 und Grundplatte 8 gebildeten Raum geleitet, die in der Flasche 4 ein Mikrowellenplasma bildete. Das Innere der Flasche bildete damit die Reaktionskammer. Durch die Gaszuführung 5 wird das zur Schichtbildung benötigte Reaktionsgas eingeleitet. Die Impulsdauer betrug bei der Erzeugung der organischen Sperrschicht 0,5 ms, bei der Erzeugung der anorganischen Sperrschicht 1 ms, die Impulspause, in der verbrauchten Reaktionsgase aus der Reaktionskammer entfernt und durch frisches Reaktionsgas ersetzt wurden betrug jeweils 100 ms. Sobald die gewünschte Schichtdicke für eine Sperrschicht auf der Fläschchenwand erzeugt war, wurde das Reaktionsgas durch das zur Erzeugung der anderen Sperrschicht erforderliche Reaktionsgas ersetzt. Zur Erzeugung eines unscharfen Übergangs zwischen organischer und anorganischer Sperrschicht kann man auch für einen gewissen Zeitraum ein Gemisch aus beiden Reaktionsgasen einleiten. Für gleichmäßige Übergänge kann man dabei den Anteil des ersten Reaktionsgases stetig vermindern und gleichzeitig den Anteil des zweiten Reaktionsgases stetig (bis auf den Nennwert) erhöhen.

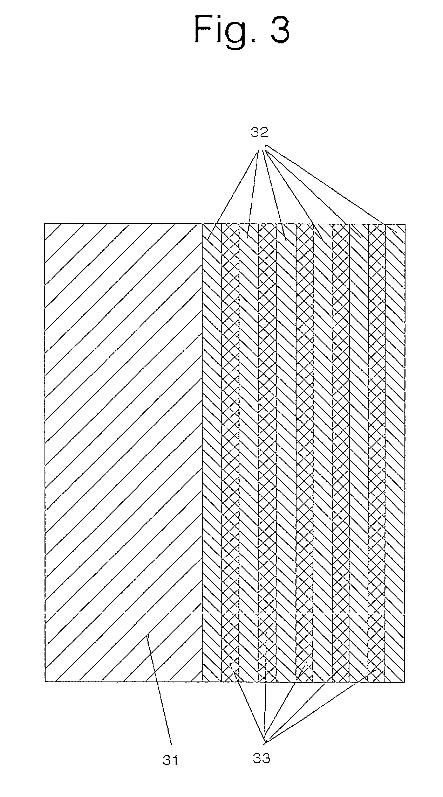

Das PICVD-Verfahren ist seit langem wohlbekannt und beispielsweise in DE-PS 40 08 405 oder auch US-PS 51 54 943 beschrieben. Die anorganische Sperrschicht wurde aus TiCl₄ erzeugt und die organische Sperrschicht aus Hexamethyldisiloxan. Die organische Sperrschicht enthielt 2 Silizium-Atome pro Kohlenstoffatom. Figur 3 zeigt schematisch und nicht maßstabsgetreu einen Ausschnitt aus der Fläschchenwand im Querschnitt. Auf die Innenseite der Behälterwandung 31 sind abwechselnd organische Sperrschichten 32 und anorganische Sperrschichten 33 aufgetragen.

Die Diffusionswerte für das beschichtete Fläschchen waren wie folgt: CO₂: 7,5 cm³/m²/d/bar, was eine Verbesserung um den Faktor 92 gegenüber der unbeschichteten Flasche bedeutet; O²: 0,375 cm³/m²/d/bar, was eine Verbesserung um den Faktor 370 bedeutet und Wasser: 0,23 g/m²/d, was eine Verbesserung um den Faktor 11 bedeutet.
Zum Test der Beständigkeit der beschichteten Flasche gegenüber einer Sterilisation im Autoklaven wurde die beschichtete Flasche 30 Minuten bei 121 °C autoklaviert. Zur Sichtbarmachung eventuell aufgetretener Risse wurde die Flasche anschließend mit Aceton gefüllt. Auftretende Risse werden als weiße Linien sichtbar, da Aceton als Lösungsmittel für Polycarbonat wirkt. Es konnten keine Risse gefunden werden.

Die Stabilität der Sperrbeschichtung gegen Rißbildung bei mechanischer Beanspruchung wurde ermittelt, indem der runde Querschnitt der Flasche 5 mal zu einem Oval mit 75 % des ursprünglichen Durchmessers gestaucht wurde. Nach der Befüllung mit Aceton wurden keine Risse sichtbar. Eine Vergleichsprobe, bei der auf die Behälterwand lediglich eine 100 nm dicke TiO₂-Schicht aufgebracht war, zeigte unter gleichen Stauchbedingungen im Bereich der Stauchung zahlreiche Haarrisse an.

### Beispiele 2 - 16:

Entsprechend Beispiel 1, wurden Polycarbonatfläschchen mit einer Sperrbeschichtung versehen. Die erste, an der Behälterwand anliegende, sowie die letzte Schicht waren jeweils organische Sperrschichten, d.h. die Anzahl der organischen Sperrschichten war um eine größer als die der anorganischen Sperrschichten. Die organischen Sperrschichten wurden analog Beispiel 1 aufgebracht und hatten die dort angegebene Zusammensetzung sowie eine Dicke von jeweils 70 ± 10 nm. Es wurden Fläschchen mit einer unterschiedlichen Anzahl von anorganischen Sperrschichten mit unterschiedlicher Dicke und aus unterschiedlichem Material hergestellt. Für diese Fläschchen wurde die Sauerstoffdiffusion ermittelt, ferner wurden die Fläschchen gemäß Beispiel 1 autoklaviert und mitteis des Acetontests gemäß Beispiel 1 auf beim Autoklavieren entstandene Risse untersucht. Beispiel 2 und Beispiel 6 sind Vergleichsbeispiele. Die Ergebnisse sind in der Tabelle zusammengefaßt, wobei nur die anorganischen Schichten gesondert aufgeführt sind.

**Tabelle**

| Beispiel Nr. | Anorganische Schicht | | | O₂-Diffusion [cm³/m²/d/bar] | Rißbildung | Bemerkung |
|---|---|---|---|---|---|---|
| | Material | Schichtenzahl | Schichtdicke [nm] | | | |
| 2 | unbeschichtet | | | 138 | | z. Vergl. |
| 3 | TiO₂ | 5 | 20 | 0,375 | nein | |
| 4 | TiO₂ | 5 | 8 | 1,83 | nein | |
| 5 | TiO₂ | 2 | 50 | 0,45 | nein | |
| 6 | TiO₂ | 1 | 500 | nicht gemessen | sehr stark | z. Vergl. |
| 7 | TiO₂ | 1 | 200 | 0,475 | nein | |
| 8 | SiO₂ | 10 | 8 | 0,825 | nein | |
| 9 | TiO₂ | 10 | 8 | 0,625 | nein | |
| 10 | TiO₂ | 50 | 2 | 3,6 | nein | |
| 12 | TiO₂ | 50 | 4 | 1,63 | nein | |
| 13 | TiO₂ | 10 | 10 | 0,5 | nein | |
| 14 | SiO₂ | 10 | 20 | 0,65 | nein | |
| 15 | TiO₂ | 16 | 10 | 0,39 | nein | |
| 16 | SiO₂ | 5 | 50 | 0,55 | nein | |

### Beispiel 17:

Dieser Beispiel beschreibt keine Ausführungsform der vorliegenden Erfindung

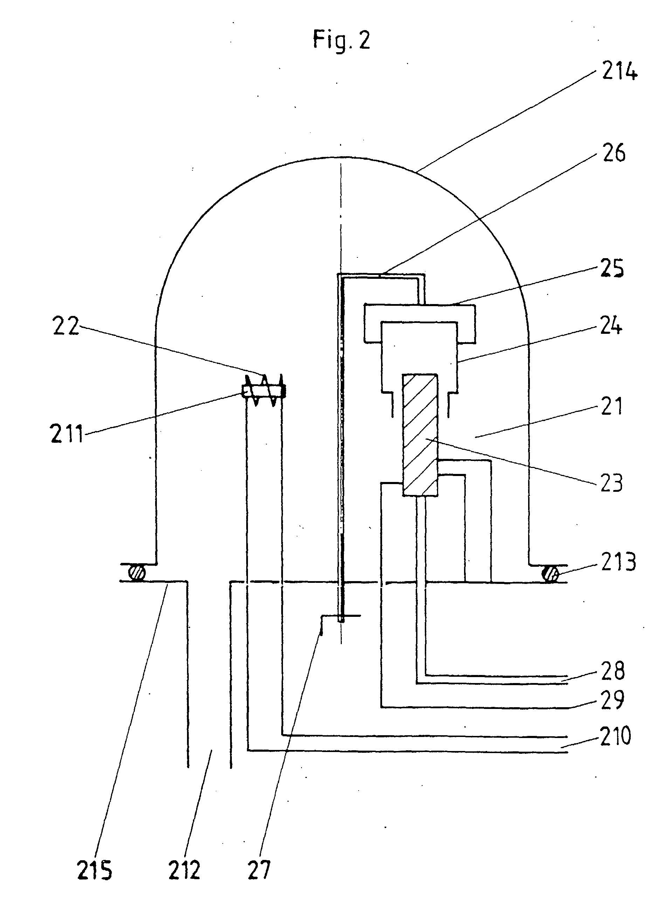

In einer in Figur 2 schematisch dargestellten Hochvakuumverdampfungsanlage (Typ BA 510, Hersteller: Balzers), die zwei unterschiedliche Beschichtungsstationen enthält, wurde ein Schichtenpaket bestehend aus 3 SiO-Schichten mit einer Stärke von jeweils 30 nm und 4 organischen Sperrschichten, hergestellt aus Hexamethyldisiloxan mit einer Stärke von 10 nm und einem Gehalt von 2,5 Si-Atomen pro C-Atom hergestellt. Die Vorrichtung besteht aus einer Grundplatte 215, die mit einem Vakuumanschlußstutzen 212 versehen ist. Eine Vakuumglocke 214 ist mit dieser Grundplatte mittels einer Dichtung 213 vakuumdicht verbunden. Eine Beschichtungsstation besteht aus einer Glühwendel 22 innerhalb derer eine SiO-Tablette 211 angeordnet ist, die das Material für die zu erzeugende anorganische Sperrschicht bildet. Die Energieversorgung der Glühwendel erfolgt über die Leitungen 210. Die andere Beschichtungseinrichtung arbeitet nach dem PCVD-Gasentladungsverfahren und besteht aus der Elektrode 22, und der Hochspannungszuführung 29. Die Elektrode 23 ragt teilweise in den zu beschichtenden Behälter 24 hinein, der mittels der Haltevorrichtung 25 an einer Drehschiebedurchführung 26 befestigt ist. Die Drehschiebedurchführung 26 kann mittels des Handgriffs 27 gehoben und gesenkt sowie gedreht werden, so daß der Behälter 24 zwecks Beschichtung mit SiO über die Wendel 22 und zwecks Beschichtung mit der organischen Sperrschicht über die Elektrode 23 gestülpt werden kann. Die Elektrode 23 ist hohl, so daß über die Leitung 28 Hexamethyldisiloxan in den Behälter 24 geleitet werden kann und durch das Hochspannungsplasma in Form einer organischen Schicht in der Behälterinnenwandung niedergeschlagen wird.

In der Beschichtungseinrichtung wird ein Druck von 0,001 mbar eingestellt, und an die Elektrode 23 wird eine Gleichspannung von - 2,5 kV gelegt, so daß in dem eingeleiteten Hexamethyldisiloxan eine Plasmaentladung stattfindet. Dabei scheidet sich an der Flascheninnenwand eine polymere organische Sperrschicht mit einem Gehalt von 2,5 Si-Atomen pro Kohlenstoffatom ab. Sobald eine Schichtdicke der organischen Sperrschicht von 10 nm erreicht ist, werden Gaszufuhr und Hochspannung abgeschaltet und die Flasche anschließend mittels der Drehschiebedurchführung so über der Wendel (22) positioniert, daß sich die Wendel in der Flaschenmitte befindet. Bei einem Druck von 0,0001 mbar wird nunmehr durch Erhitzen der Wendel mittels elektrischen Stroms SiO aus der innerhalb der Wendel befindlichen SiO Tablette verdampft, das sich an der Innenseite der Flasche auf der bereits dort befindlichen organischen Sperrschicht niederschlägt. Nach Erreichen einer Schichtdicke von 30 nm wird die Flasche wieder über den Plasmabeschichtungsteil geschwenkt und die nächste organische Schicht aufgebracht. Ohne Unterbrechung des Vakuums wurden auf diese Weise weitere 3 organische Sperrschichten und 2 aus SiO bestehende anorganische Sperrschichten aufgebracht, so daß die gesamte Sperrbeschichtung aus 4 organischen Sperrschichten und 3 anorganischen Sperrschichten bestand. Die Sauerstoffpermeation betrug 0,62 cm³/m²/d/bar, was einer Verringerung der Sauerstoffpermeation um den Faktor 222 entspricht.

### Beispiel 18:

Dieser Beispiel beschreibt keine Ausführungsform der vorliegenden Erfindung.

In einer Anlage analog Figur 2, jedoch mit dem Unterschied, daß anstelle der Plasmabeschichtungsstation eine weitere Verdampferstation mit einem beheizten Wolframtiegel vorhanden ist, in dem sich Paracyclophan befindet. Beim Erhitzen wird das Paracyclophan zu monomeren biradikalischem p-Xylylen pyrolysiert, was bei Temperaturen unter 35 °C zu einem Poly-p-xylylen-Film (Trivialname: Poly-para-Xylol- oder Parylen-Film) polymerisiert. Auf die Innenseite des Fläschchens werden, beginnend mit einer 10 nm dicken Parylenschicht abwechselnd insgesamt vier 10 nm dicke Parylenschichten und drei 30 nm dicke SiO-Schichten aufgebracht. Die CO₂-Permeation für diese Beschichtung beträgt 8,3 cm³/m²/d/bar, was einer Verringerung der CO₂-Permeation gegenüber der unbeschichteten Flasche um den Faktor 83 entspricht.

### Beispiel 19:

Analog Beispiel 1 wurde ein Fläschchen beschichtet mit 6 jeweils 50 nm dicken organischen Sperrschichten, hergestellt aus Hexamethyldisiloxan und 5 dazwischen angeordneten anorganischen Sperrschichten aus TiO₂. Die organischen Sperrschichten enthielten 3.3 Si-Atome pro Kohlenstoffatom. Die erste auf die Behälterwand aufgebrachte Schicht war eine organische Sperrschicht. Die anorganischen Sperrschichten hatten unterschiedliche Dicken und zwar, aus Richtung der Behälterwandung gesehen: 50 nm, 40 nm, 30 nm, 20 nm, 10 nm. Das so beschichtete Fläschchen hatte eine O₂-Diffusion von 0,42 cm³/m²/d/bar. Ein Acetonangriff nach dem Autoklavieren war nicht erkennbar.

### Beispiel 20:

Nach dem in Beispiel 1 beschriebenen Verfahren wurde eine Sperrbeschichtung aus 5 anorganischen und 6 organischen Sperrschichten erzeugt, bei der die anorganischen Sperrschichten eine unterschiedliche Zusammensetzung und unterschiedliche Dicke besaßen. Die organischen Sperrschichten besaßen eine Dicke und Zusammensetzung gemäß Beispiel 19. Die anorganischen Sperrschichten waren, aus Richtung Behälterwand gesehen, wie folgt angeordnet: 30 nm TiO₂, 20 nm SiO₂, 30 nm TiO₂, 20 nm SiO₂ und 30 nm TiO₂. Die Fläschchen hatten eine O₂-Diffusion von 0,48 cm³/m²/d/bar. Ein Acetonangriff war nicht feststellbar.

### Beispiel 21:

Analog zu Beispiel 1 wurde ein Fläschchen mit 5 anorganischen Sperrschichten, einer Dicke von je 50 nm aus TiO₂ und 6 organischen, aus Hexamethyldisiloxan hergestellten Sperrschichten versehen, bei der die organischen Sperrschichten eine anisotrope Verteilung der Metallatome in der Schicht hatten. Die organischen Sperrschichten hatten eine Dicke von jeweils 50 nm. Das Verhältnis Si:C betrug an den Grenzflächen etwa 6 Si-Atome pro C-Atom und fiel annähernd parabolisch zur Mitte der organischen Sperrschicht auf 3 Si-Atome pro C-Atom ab. Die Sauerstoffdiffusion bei dem beschichteten Fläschchen betrug 0,43 cm³/m²/d/bar. Ein Acetonangriff nach dem Autoklavieren war nicht feststellbar.

## Patentansprüche

1. Verfahren zur Herstellung eines mit einer Sperrbeschichtung versehenen Behälters aus Kunststoff, wobei auf die Behälterwandung abwechselnd Schichten aus einem anorganischen Oxid, Nitrid oder Oxinitrid oder einer Mischung davon (anorganische Sperrschicht) und Schichten aus einem organischen polymeren Material (organische Sperrschicht) aufgebracht werden und das Verfahren beendet wird, wenn mindestens jeweils eine anorganische Sperrschicht und jeweils eine organischen Schicht aufgebracht sind,
**dadurch gekennzeichnet,**
daß die einzelnen Sperrschichten (anorganische und organische) nacheinander in ein und demselben Verfahren mittels PCVD (Plasma-Chemical-Vapour-Deposition) auf die Behälterwandung abgeschieden werden.

2. Verfahren nach Anspruch 1,
**dadurch gekennzeichnet,**
daß man die einzelnen Schichten mittels eines PICVD (Plasma-lmpulse-Chemical-Vapour-Deposition)-Verfahrens aufbringt.

3. Verfahren nach Anspruch 1 oder 2,
**dadurch gekennzeichnet,**
daß man die anorganischen Sperrschichten in einer Dicke von 2 bis 300 nm und die organischen Sperrschichten in einer Dicke von 2 bis 1000 nm aufbringt.

4. Verfahren nach wenigstens einem der Ansprüche 1 bis 3
**dadurch gekennzeichnet,**
daß man Schichten bis zu einer Gesamtdicke des Schichtenpakets von höchstens 0,1 mm aufbringt.

5. Verfahren nach wenigstens einem der Ansprüche 1 bis 4
**dadurch gekennzeichnet,**
daß man eine organische Sperrschicht aufbringt, die mit 0,1 bis 10 Metallatomen pro Kohlenstoffatom dotiert ist.

6. Verfahren nach Anspruch 5,
**dadurch gekennzeichnet,**
daß man ein organische Sperrschicht aufbringt, die mit dem gleichen Metallatom dotiert ist, die auch in der anorganischen Sperrschicht vorhanden sind.

7. Verfahren nach den Ansprüchen 5 oder 6
**dadurch gekennzeichnet,**
daß man eine metallatomhaltige organische Sperrschicht dergestalt aufbringt, daß die Konzentration der Metallatome in der Schichtmitte geringer als an der zu einer anorganischen Schicht weisenden Grenzfläche ist.

8. Verfahren nach wenigstens einem der Ansprüche 1 bis 7,
**dadurch gekennzeichnet,**
daß man das Verfahren derart steuert, daß in der abgeschiedenen Schicht der Übergang von einer organischen zu einer anorganischen Sperrschicht in Bezug auf die Zusammensetzung kontinuierlich verläuft.

## Claims

1. Process for producing a plastic container provided with a barrier coating, where layers of an inorganic oxide, nitride or oxynitride or a mixture of these (inorganic barrier layer) and layers of an organic polymeric material (organic barrier layer) are applied alternately to the container wall, and the process is terminated when at least one inorganic barrier layer in each case and one organic layer in each case have been applied,
**characterized in that**
the individual barrier layers (inorganic and organic) are deposited onto the container wall one after the other in one and the same process using PCVD (plasma chemical vapour deposition).

2. Process according to Claim 1,
**characterized in that**
the individual layers are applied using a PICVD (plasma impulse chemical vapour deposition) process.

3. Process according to Claim 1 or 2,
**characterized in that**
the inorganic barrier layers are applied in a thickness of from 2 to 300 nm and the organic barrier layers in a thickness of from 2 to 1000 nm.

4. Process according to at least one of Claims 1 to 3,
**characterized in that**
layers are applied until the overall thickness of the assembly of layers is not more than 0.1 mm.

5. Process according to at least one of Claims 1 to 4,
**characterized in that**
an organic barrier layer which has been doped with from 0.1 to 10 metal atoms per carbon atom is applied.

6. Process according to Claim 5,
**characterized in that**
an organic barrier layer which is doped with a metal atom which is the same as those also present in the inorganic barrier layer is applied.

7. Process according to Claim 5 or 6,
**characterized in that**
an organic barrier layer containing a metal atom is applied in such a way that the concentration of the metal atoms in the middle of the layer is lower than at the boundary surface which faces an inorganic layer.

8. Process according to at least one of Claims 1 to 7,
**characterized in that**
the process is controlled in such a way that, in the layer deposited, there is a continuous transition of composition from an organic to an inorganic barrier layer.

## Revendications

1. Procédé de fabrication d'un récipient en matière plastique pourvu d'un revêtement barrière, dans lequel on applique sur la paroi du récipient des couches alternées d'un oxyde, d'un nitrure ou d'un oxynitrure minéral ou d'un de leurs mélanges (couche barrière minérale) et des couches constituées d'un matériau polymère organique (couche barrière organique) et dans lequel le procédé est terminé lorsqu'au moins, respectivement, une couche barrière minérale et, respectivement, une couche organique ont été appliquées, caractérisé en ce que les couches barrières individuelles (minérales et organiques) sont produites successivement au moyen d'un seul et même procédé par PCVD (Plasma-Chemical-Vapour-Deposition) sur la paroi du récipient.

2. Procédé selon la revendication 1, caractérisé en ce que l'on applique les couches individuelles au moyen d'un procédé PICVD (Plasma-Impulse-Chemical-Vapour-Deposition).

3. Procédé selon la revendication 1 ou 2, caractérisé en ce que les couches barrières minérales sont appliquées sur une épaisseur de 2 à 300 nm et les couches barrières organiques sur une épaisseur de 2 à 1000 nm.

4. Procédé selon au moins l'une quelconque des revendications 1 à 3, caractérisé en ce que l'on applique des couches jusqu'à une épaisseur totale maximale du paquet de couches de 0,1 mm.

5. Procédé selon au moins l'une quelconque des revendications 1 à 4, caractérisé en ce que l'on applique une couche barrière organique, qui est dopée par 0,1 à 10 atomes de métal par atome de carbone.

6. Procédé selon la revendication 5, caractérisé en ce que l'on applique une couche barrière organique qui est dopée par le même atome de métal que celui qui est présent également dans la couche barrière minérale.

7. Procédé selon la revendication 5 ou 6, caractérisé en ce que l'on applique une couche barrière organique contenant des atomes de métal de telle sorte que la concentration des atomes de métal au centre de la couche soit plus faible qu'à la surface limite faisant face à une couche minérale.

8. Procédé selon au moins l'une quelconque des revendications 1 à 7, caractérisé en ce que l'on commande le procédé de telle sorte que, dans la couche produite, la transition d'une couche barrière organique à une couche barrière minérale se fasse en continu par rapport à la structure.
